# FASCICULE DE BREVET EUROPEEN

(11) **EP 3 944 322 B1**
(45) Date de publication et mention de la délivrance du brevet: **22.05.2024**
(21) Numéro de dépôt: 21186804.7
(22) Date de dépôt: 20.07.2021
(51) Int. Cl.: H01L 27/13, H01L 21/84, H01L 21/762

(54) **PROCÉDÉ DE FABRICATION D'UN DISPOSITIF MICROÉLECTRONIQUE**
VERFAHREN ZUR HERSTELLUNG EINER MIKROELEKTRONISCHEN VORRICHTUNG
METHOD FOR MANUFACTURING A MICROELECTRONIC DEVICE

(30) Priorité: 22.07.2020 FR 2007684
(43) Date de publication de la demande: 26.01.2022
(73) Titulaire: Commissariat à l'énergie atomique et aux énergies alternatives, 75015 Paris (FR)
(72) Inventeur: NIEBOJEWSKI, Heimanu, 38054 GRENOBLE CEDEX 09 (FR); ANDRIEU, François, 38054 GRENOBLE CEDEX 09 (FR); FENOUILLET-BERANGER, Claire, 38054 GRENOBLE CEDEX 09 (FR)
(74) Mandataire: Brevalex

(56) Documents cités:
- EP-A1- 3 531 444
- WO-A1-2017/142849
- FR-A1- 3 091 004
- US-A1- 2002 079 537
- US-A1- 2002 171 120
- US-A1- 2012 025 345
- US-A1- 2014 084 412
- US-A1- 2020 219 760

## Description

### DOMAINE TECHNIQUE

L'invention concerne le domaine des procédés de co-intégration de dispositifs micro-électroniques sur un substrat de silicium sur isolant (« SOI »). En particulier, la présente invention vise à proposer un procédé de fabrication de composants actifs, et notamment digitaux, sur ou dans l'empilement formé par la couche de silicium et la couche d'isolant du substrat SOI, et des composants, par exemple des composants radiofréquences (« RF ») ou passif, au niveau de zones pour lesquelles l'empilement a été retiré. À cet égard, le procédé proposé dans le cadre de la présente invention permet de s'affranchir de la présence d'une couche de piégeage généralement mise en oeuvre dans les substrats SOI HR.

### ÉTAT DE LA TECHNIQUE ANTÉRIEURE

Les substrats de silicium sur isolant (« SOI » ou « Silicon On Insulator » selon la terminologie Anglo-Saxonne) sont aujourd'hui largement utilisés, et depuis de nombreuses années, pour la fabrication de dispositifs micro-électroniques.

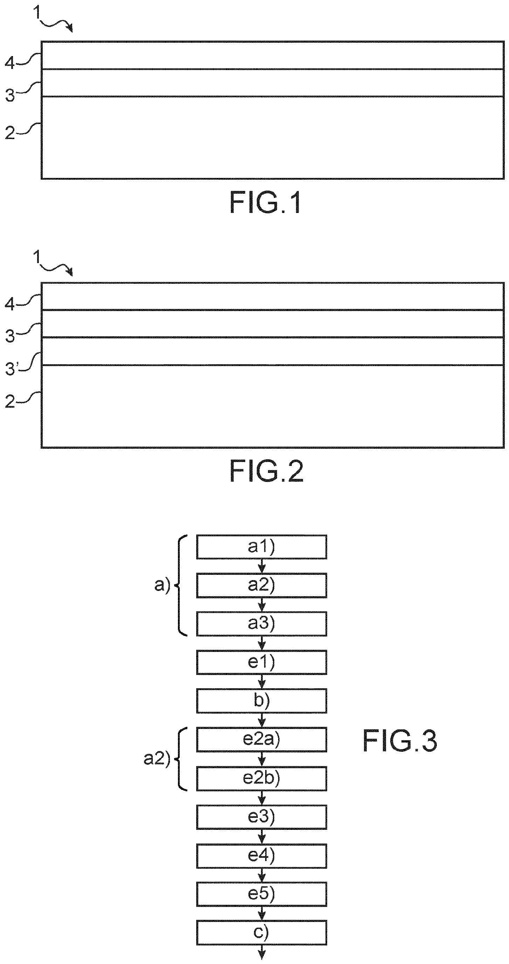

Ces substrats 1 comprennent une couche isolante 3, intercalée entre une couche de silicium 4 et un substrat support 2, destinée à isoler électriquement les composants (notamment les transistors) d'un même dispositif micro-électronique (figure 1).

Cependant dès lors qu'il s'agit de fabriquer des dispositifs radiofréquences (ci-après « RF ») ou des composants passifs tels que des inductances, cette seule couche isolante ne suffit plus à assurer un fonctionnement optimal desdits dispositifs. En effet, ces derniers, lorsqu'ils fonctionnent, sont le siège de phénomènes parasites qui perturbent leur fonctionnement et affectent *de facto* leurs performances. Parmi les phénomènes parasites susceptibles d'être observés, les diaphonies, les non-linéarités, ou encore les courants de Foucault (« Eddy Currents » selon la terminologie Anglo-Saxonne) sont les plus courants.

Afin de pallier ce problème, il est proposé, dans le document US5773151, un nouveau type de substrat SOI (figure 2), dit substrat SOI RF, et dans lequel une couche de piégeage 3' (« Trap-Rich layer » selon la terminologie Anglo-Saxonne) est intercalée entre la couche isolante 3 et le substrat support 2. La couche de piégeage 3' est notamment destinée à limiter, voire supprimer, ces effets indésirables.

Les substrats SOI RF semblent par ailleurs être des candidats de choix pour la co-intégration de dispositifs RF et digitaux par exemple. Toutefois, ces dispositifs digitaux, qui peuvent notamment comprendre des diodes, des transistors bipolaires ou encore des composants CMOS, voient généralement leurs performances altérées par la présence de la couche de piégeage.

Cette co-intégration nécessite par conséquent de former sur un même substrat des zones de SOI RF, et des zones SOI dépourvues de couche de piégeage. Une telle configuration est notamment décrite dans le document US 2018/0069079. Il est en particulier proposé dans ce document de former des zones SOI RF dans un substrat SOI par mise en oeuvre d'une étape d'implantation localisée d'espèces.

Le procédé proposé n'est toutefois pas satisfaisant.

En effet, il est généralement observé à l'issue de l'étape d'implantation, une diffusion latérale des espèces qui se traduit par une variabilité des propriétés des composants formés sur des zones SOI adjacentes.

Par ailleurs, la présence d'une couche de piégeage ou d'une zone de piégeage selon les termes du document US 2018/0069079 impose des contraintes d'utilisation du substrat considéré, et notamment des contraintes en termes de budget thermique.

Enfin, la fabrication de composants digitaux s'accompagne généralement de la formation de tranchées d'isolation. Ces dernières, dont la principale fonction est d'assurer une isolation électrique entre les composants digitaux, ne sont que peu valorisées.

On notera que des composants micro électroniques comprenant notamment des couches de piégeage et/ou des tranchés d'isolation sont connus des documents FR 3091004 A1, US 2012/025345 A1, US 2002/171120 A1, EP 3531444 A1, WO 2017/142849 A1, US 2020/219760 A1, US 2002/079537 A1 et US 2014/084412 A1.

Un but de la présente invention est de proposer un procédé de co-intégration de composants logiques, RF et/ou passifs sur un même substrat sans avoir recours à la formation d'une couche de piégeage.

Un autre but de la présente invention est de proposer un procédé de co-intégration de composants logiques, RF et/ou passifs sur un même substrat permettant de s'affranchir des contraintes imposées par une couche de piégeage.

Un autre but de la présente invention est de proposer un procédé de co-intégration de composants logiques, RF et/ou passifs sur un même substrat permettant de valoriser l'espace occupé par des tranchées d'isolation.

### EXPOSÉ DE L'INVENTION

Les buts de la présente invention sont, au moins en partie, atteints par un procédé de fabrication d'un dispositif microélectronique comprenant :
a) une étape de fourniture d'un substrat de semi-conducteur sur isolant comprenant un substrat support sur une face duquel, dite face principale, repose au moins deux empilements pourvus chacun, dans l'ordre et à partir de la face principale, d'une couche de diélectrique et d'une couche de semi-conducteur, chaque empilement formant un îlot sur lesquels un ou des composants actifs sont destinés à être formés, chaque îlot est délimité latéralement par des flancs, dits premiers flancs, et les îlots sont séparés les uns des autres par au moins une tranchée d'isolation qui s'étend sur au moins toute l'épaisseur de l'empilement jusqu'à un premier fond formé sur ou dans le substrat support, chaque tranchée d'isolation étant destinée à être remplie d'un premier matériau diélectrique,
b) une étape de rugosification d'une section passive du premier fond de la tranchée d'isolation destinée à générer, au niveau de ladite section, une moyenne quadratique de rugosité comprise entre 2 nm et 6 nm,
c) une étape de formation d'un composant, dit composant passif, en recouvrement du premier matériau diélectrique et à l'aplomb de la section passive.

Selon un mode de mise en oeuvre l'étape b) de rugosification comprend une gravure exécutée au moyen d'une solution de gravure liquide, la solution de gravure liquide comprenant avantageusement au moins une des solutions choisies parmi : solution SC1, solution d'ammoniaque pur, solution TMAH ou KOH.

Alternativement, l'invention concerne un procédé de fabrication d'un dispositif microélectronique comprenant :
a) une étape de fourniture d'un substrat de semi-conducteur sur isolant comprenant un substrat support sur une face duquel, dite face principale, repose au moins deux empilements pourvus chacun, dans l'ordre et à partir de la face principale, d'une couche de diélectrique et d'une couche de semi-conducteur, chaque empilement formant un îlot sur lesquels un ou des composants actifs sont destinés à être formés, chaque îlot est délimité latéralement par des flancs, dits premiers flancs, et les îlots sont séparés les uns des autres par au moins une tranchée d'isolation qui s'étend sur au moins toute l'épaisseur de l'empilement jusqu'à un premier fond formé sur ou dans le substrat support, chaque tranchée d'isolation étant destinée à être remplie d'un premier matériau diélectrique,
b) une étape de rugosification d'une section passive du premier fond de la tranchée d'isolation destinée à générer, au niveau de ladite section, une moyenne quadratique de rugosité comprise entre 2 nm et 6 nm, ladite moyenne quadratique de rugosité étant mesurée dans la gamme de fréquences spatiales allant de 20 µm⁻¹ à 50 µm⁻¹,
c) une étape de formation d'un composant, dit composant passif, en recouvrement du premier matériau diélectrique et à l'aplomb de la section passive.

Selon un mode de mise en oeuvre l'étape a) comprend l'enchainement des étapes suivantes :
- une étape a1) de formation d'une couche de matériau diélectrique de, formé avantageusement d'une couche d'oxyde de silicium, et en recouvrement de la couche de semi-conducteur du substrat de semi-conducteur sur isolant ;
- une étape a2) de formation d'un masque dur 16 destiné à délimiter les tranchées d'isolation ;
- une étape a3) de formation des tranchées d'isolation.

Selon un mode de mise en oeuvre le procédé comprend une étape e2) de remplissage des tranchées d'isolation par le premier matériau diélectrique.

Selon un mode de mise en oeuvre, le procédé comprend, après exécution de l'étape e2), une séquence e3) conduisant à la formation des composants actifs sur ou dans la couche de semi-conducteur au niveau des îlots.

Selon un mode de mise en oeuvre le procédé comprend une étape e4), exécutée après la séquence e3), de formation d'une couche d'encapsulation en recouvrement des îlots et du premier matériau remplissant les tranchées d'isolation.

Selon un mode de mise en oeuvre le procédé comprend une étape e5), exécutée après l'étape e4), de formation de contacts électriques traversant la couche d'encapsulation et destinés à contacter électriquement les composants actifs.

Selon un mode de mise en oeuvre lors de l'étape e4), une couche intermédiaire est également formée entre la couche d'encapsulation et le premier matériau remplissant les tranchées d'isolation, la couche intermédiaire étant faite d'un deuxième matériau différent du premier matériau et du matériau formant la couche d'encapsulation.

Selon un mode de mise en oeuvre l'étape b) est exécutée avant l'étape e2).

Selon un mode de mise en oeuvre l'étape b) est précédée d'une étape e1) de formation d'une couche de protection en recouvrement des îlots et des premiers flancs, ladite couche de protection étant destinée à protéger les premiers flancs de lors de l'exécution de l'étape b).

Selon un mode de mise en oeuvre l'étape b) est exécutée après l'étape e4).

Selon un mode de mise en oeuvre l'étape b) est précédée d'une séquence qui comprend les étapes suivantes :
- une étape e6) de formation d'une ouverture traversante traversant la couche d'encapsulation et la couche intermédiaire, à l'aplomb de la section passive, ladite ouverture traversante présentant une dimension caractéristique inférieure à un dixième de la distance entre les premiers flancs de la tranchée, l'ouverture traversante étant délimitée par des deuxièmes flancs et un deuxième fond au niveau duquel le premier matériau diélectrique est exposé à l'environnement extérieur,

- une étape e7) de formation d'une couche de protection en recouvrement des deuxièmes flancs, et laissant exposé à l'environnement extérieur le deuxième fond,
- une étape e8) de gravure sélective et partielle du premier matériau diélectrique au regard de la couche de protection et de la couche intermédiaire de manière à former une cavité dans le premier matériau diélectrique et délimitée par un fond formant la section passive, par des troisièmes flancs formés par le premier matériau diélectrique non gravé au cours de ladite étape de gravure, et par un plafond au niveau de la couche intermédiaire.

Selon un mode de mise en oeuvre l'étape b) est suivie d'une étape e9) destinée à combler l'ouverture traversante avec un troisième matériau diélectrique.

Selon un mode de mise en oeuvre, le troisième matériau diélectrique vient également tapisser la section passive, les troisièmes flancs et le plafond de la cavité.

L'invention concerne également un dispositif micro-électronique formé sur un substrat support et sur une face duquel, dite face principale, reposent des îlots comprenant chacun un empilement, l'empilement étant pourvu, dans l'ordre et à partir de la face principale, d'une couche diélectrique et d'une couche de semi-conducteur, les îlots sont délimités latéralement par des flancs, dits premiers flancs, et sont séparés les uns des autres par des tranchées d'isolation qui s'étendent sur au moins toute l'épaisseur de l'empilement jusqu'à un premier fond formé sur ou dans le substrat support,
le dispositif comprenant une section passive sur le premier fond des tranchées d'isolation qui présente une moyenne quadratique de rugosité comprise entre 2 nm et 6 nm, et le dispositif comprenant en outre un composant, dit composant passif, en recouvrement d'un premier matériau diélectrique remplissant les tranchées d'isolation et à l'aplomb de la section passive.

### BRÈVE DESCRIPTION DES DESSINS

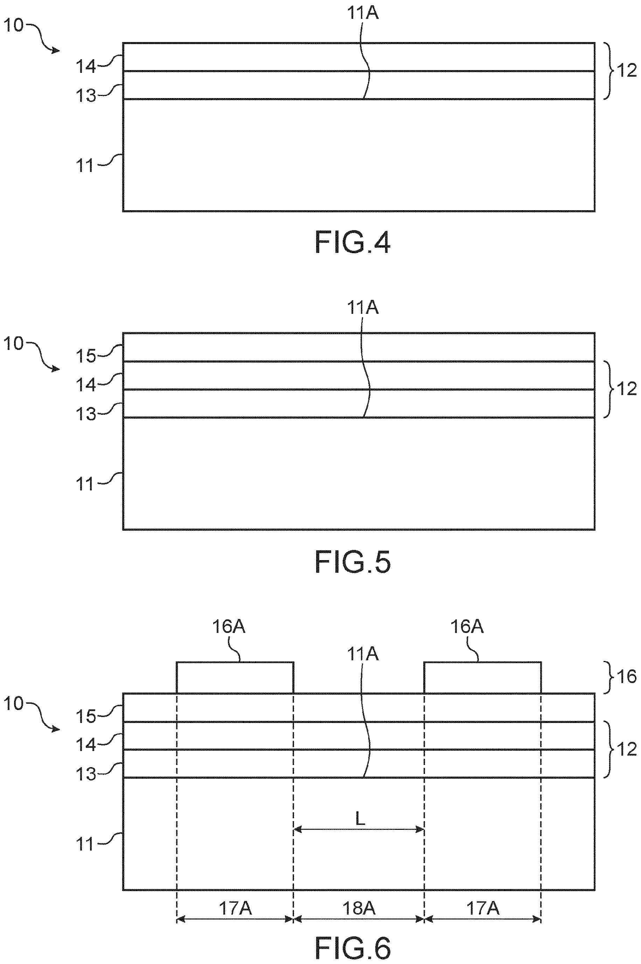

D'autres caractéristiques et avantages apparaîtront dans la description qui va suivre d'un procédé de fabrication d'un dispositif microélectronique selon l'invention, donnés à titre d'exemples non limitatifs, en référence aux dessins annexés dans lesquels :
La figure 1 est une représentation schématique d'un substrat SOI connu de l'état de la technique et dépourvu de couche de piégeage, le substrat SOI est notamment représenté selon un plan de coupe perpendiculaire à une face principale du dudit substrat SOI ;
la figure 2 est représentation schématique d'un substrat SOI RF de l'état de la technique et pourvu d'une couche de piégeage intercalée entre la couche d'isolant et le substrat support, le substrat SOI RF est notamment représenté selon un plan de coupe perpendiculaire à une face principale du dudit substrat SOI ;
la figure 3 est une représentation des étapes mises en oeuvre du procédé de fabrication d'un dispositif microélectronique selon un premier mode de réalisation de la présente invention ;
le figure 4 est une représentation schématique d'un substrat de semi-conducteur sur isolant mis en oeuvre dans le cadre d'un premier mode de réalisation de la présente invention, le substrat de semi-conducteur sur isolant est notamment représenté selon un plan de coupe perpendiculaire à une face principale d'un substrat support à partir duquel est formé le substrat de semi-conducteur sur isolant ;
la figure 5 est une représentation schématique d'une étape a1) mise en oeuvre dans le cadre du premier mode de réalisation de la présente invention ;
la figure 6 est une représentation schématique d'une étape de formation d'un masque dur sur la couche de matériau diélectrique formée lors l'exécution de l'étape a2) ;

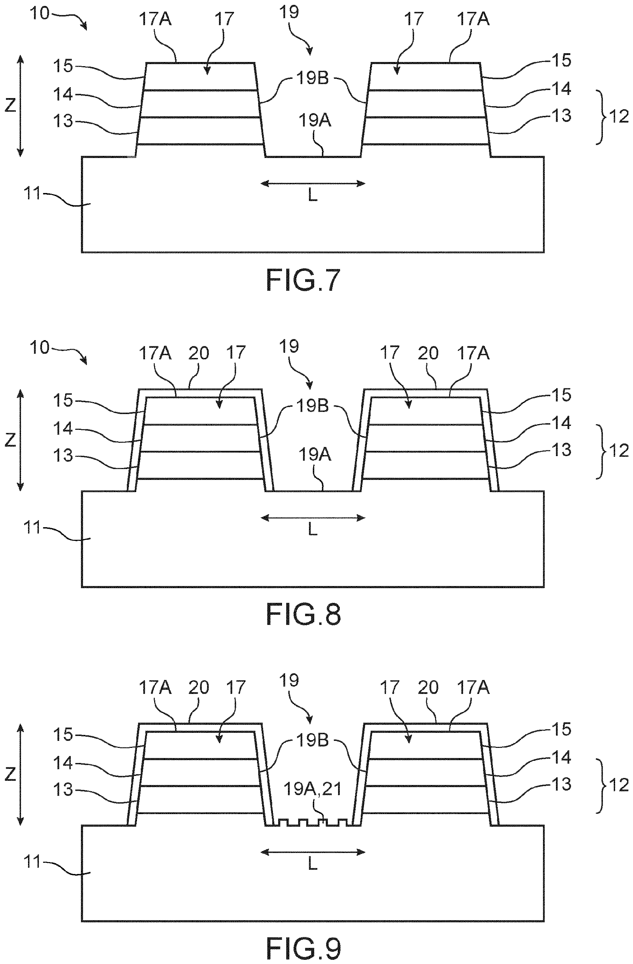

la figure 7 est une représentation schématique d'une étape a3) mise en oeuvre dans le cadre du premier mode de réalisation de la présente invention ;
la figure 8 est une représentation schématique d'une étape e1) de formation d'une couche de protection des premiers flancs et des zones actives, et laissant exposée à l'environnement extérieur les premiers fonds, cette étape étant mise en oeuvre dans le cadre du premier mode de réalisation de la présente invention ;
la figure 9 est une représentation schématique d'une étape b) mise en oeuvre dans le cadre du premier mode de réalisation de la présente invention ;

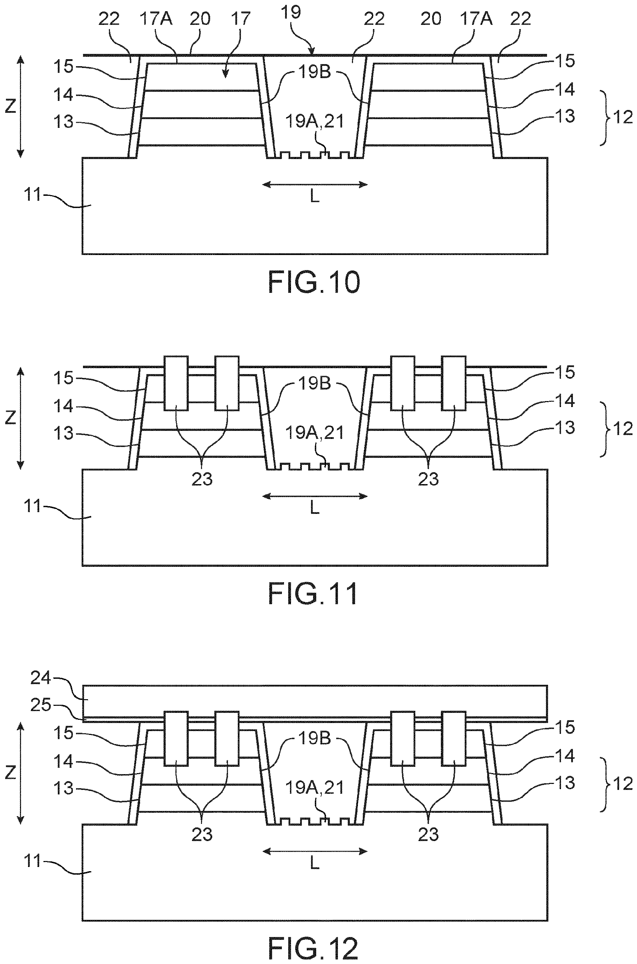

la figure 10 est une représentation schématique d'une étape e2) mise en oeuvre dans le cadre du premier mode de réalisation de la présente invention ;
la figure 11 est une représentation schématique d'une étape e3) mise en oeuvre dans le cadre du premier mode de réalisation de la présente invention ;
la figure 12 est une représentation schématique d'une étape e4) mise en oeuvre dans le cadre du premier mode de réalisation de la présente invention ;

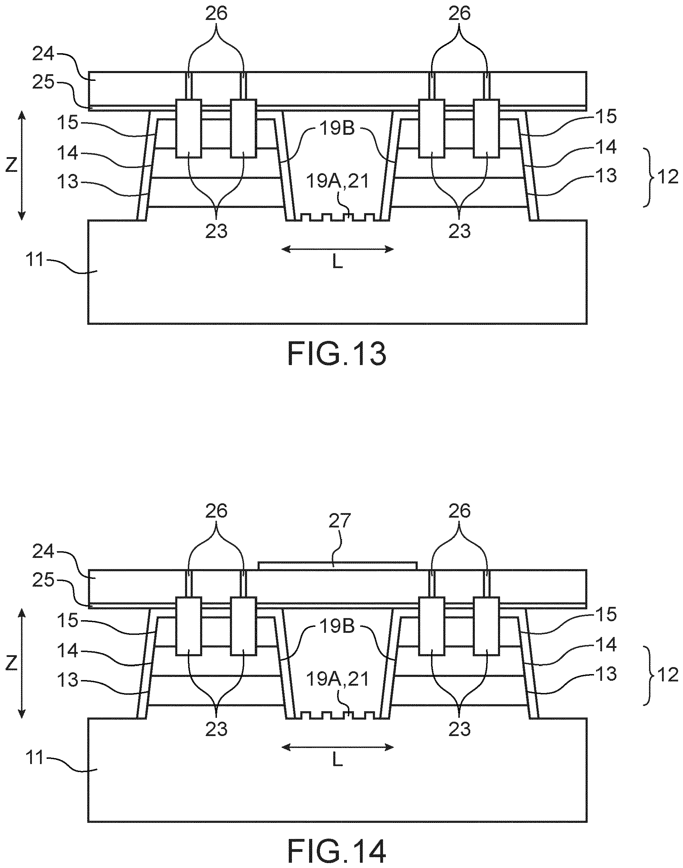

la figure 13 est une représentation schématique d'une étape e5) mise en oeuvre dans le cadre du premier mode de réalisation de la présente invention ;
la figure 14 est une représentation schématique d'une étape c) mise en oeuvre dans le cadre du premier mode de réalisation de la présente invention ;

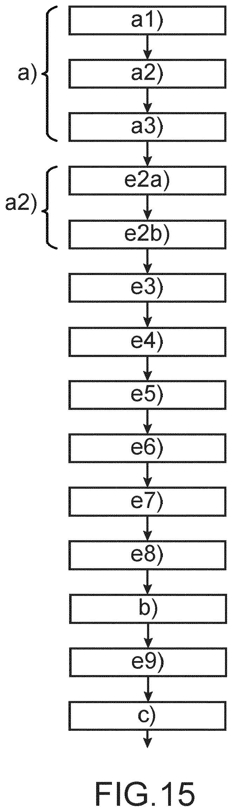

la figure 15 est une représentation des étapes mises en oeuvre du procédé de fabrication d'un dispositif microélectronique selon un deuxième mode de réalisation de la présente invention ;

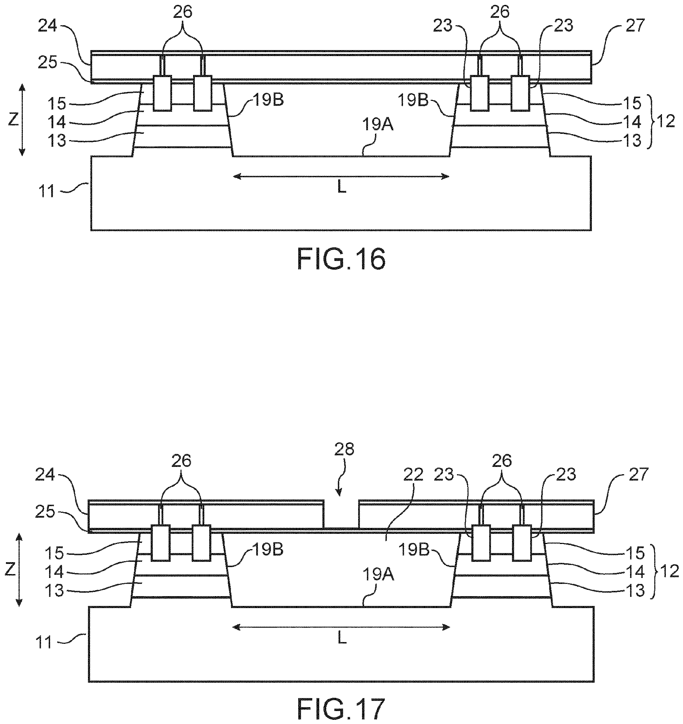

la figure 16 est une représentation schématique d'un procédé de fabrication d'un dispositif micro-électronique dans le cadre d'un deuxième mode de réalisation de la présente invention, notamment la figure 14 est une représentation de l'étape e6) ;
la figure 17 est une représentation schématique d'une étape de formation d'une ouverture traversante dans la couche intermédiaire et dans la couche d'encapsulation selon le deuxième mode de réalisation, en particulier, la figure 15 représente la gravure conduisant à la formation de ladite ouverture au niveau de la couche de d'encapsulation ;

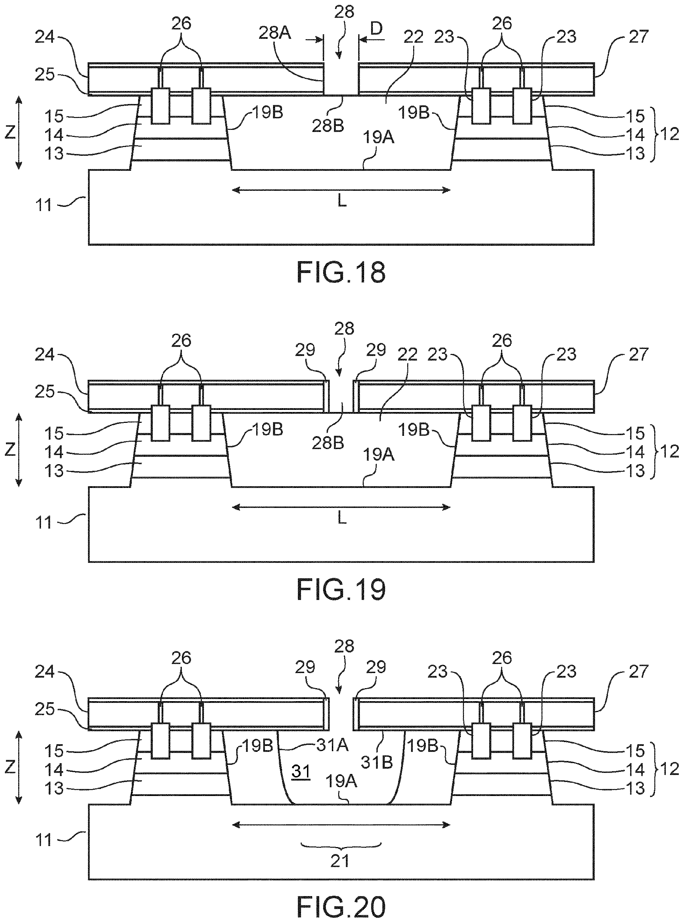

la figure 18 est une représentation schématique de l'étape e6) de formation d'une ouverture traversante dans la couche intermédiaire et dans la couche d'encapsulation selon le deuxième mode de réalisation, en particulier, la figure 16 représente la gravure conduisant à la formation de ladite ouverture au niveau de la couche intermédiaire ;
la figure 19 est une représentation schématique de l'étape e7) de formation d'une couche de protection sur les deuxièmes flancs des ouvertures traversantes et mise en oeuvre dans le cadre du deuxième mode de réalisation de la présente invention ;
la figure 20 est une représentation schématique d'une étape e8) de formation d'une cavité dans le premier matériau diélectrique selon le deuxième mode de réalisation de la présente invention ;

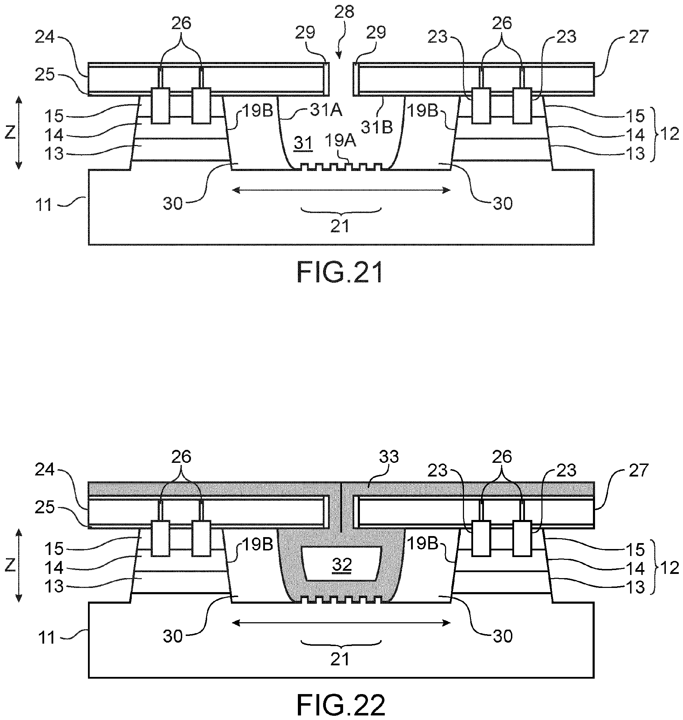

la figure 21 est représentation schématique d'une étape b) de rugosification de la section passive selon le deuxième mode de réalisation de la présente invention ;
la figure 22 est représentation schématique d'une étape e9) destinée à combler avec un troisième matériau diélectrique les ouvertures traversantes selon le deuxième mode de réalisation de la présente invention ;

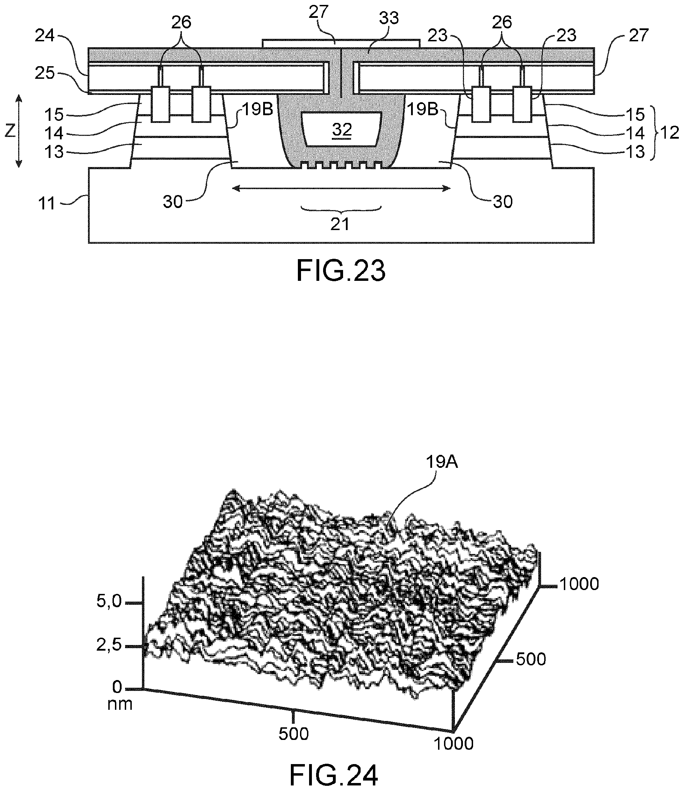

la figure 23 est une représentation schématique d'une étape c) mise en oeuvre dans le cadre du deuxième mode de réalisation de la présente invention ;
la figure 24 illustre une image de microscopie atomique de la section passive avant le remplissage de la tranché correspondante avec

### EXPOSÉ DÉTAILLÉ DE MODES DE RÉALISATION PARTICULIERS

La présente invention concerne un procédé de co-intégration de composants actifs et de composants passifs à partir d'un substrat SOI formé d'un substrat support et sur une face duquel, dite face principale, repose un empilement pourvu, dans l'ordre et à partir de la face principale, d'une couche diélectrique et d'une couche de semi-conducteur. Le substrat SOI peut avantageusement être un substrat SOI à désertion complète (« FDSOI » ou « Fully Depleted Silicon on Insulator » selon la terminologie Anglo-Saxonne).

En particulier, les composants actifs reposent sur ou dans des îlots (formant des zones actives) qui comprennent l'empilement. Les îlots sont par ailleurs délimités latéralement par des premiers flancs, et sont séparées les uns des autres par des tranchées d'isolation qui s'étendent sur au moins toute l'épaisseur de l'empilement jusqu'à un premier fond formé sur ou dans le substrat support.

Les tranchées d'isolation sont par ailleurs remplies, au moins en partie, d'un premier matériau diélectrique.

Le procédé selon la présente invention comprend par ailleurs l'exécution des étapes suivantes :
a) une étape de fourniture du substrat support pourvu d'îlots comprenant l'empilement et sur lesquels un ou des composants actifs sont destinés à être formés, les îlots sont délimités latéralement par des flancs, dits premiers flancs, et sont séparés les uns des autres par des tranchées d'isolation qui s'étendent sur au moins toute l'épaisseur de l'empilement jusqu'à un premier fond formé sur ou dans le substrat support,
b) une étape de rugosification d'une section passive du premier fond des tranchées d'isolation destinée à générer, au niveau de ladite section, une moyenne quadratique de rugosité comprise entre 2 nm et 6 nm,
c) une étape de formation d'un composant, dit composant passif, en recouvrement du premier matériau diélectrique et, au moins en partie, à l'aplomb de la section passive.

Ainsi, selon la présente invention, la formation de la section passive, et notamment la génération d'une moyenne quadratique de rugosité (« RMS roughness » ou « Root Mean Square Roughness » selon la terminologie Anglo-Saxonne) au niveau de ladite section passive permet d'atténuer les diaphonies et / ou courants parasites générés par les composants passifs, et/ou entre composants actifs adjacents.

Il est par ailleurs entendu que la moyenne quadratique de rugosité correspond à une rugosité RMS mesurée dans la gamme de fréquences spatiales allant de 20 µm⁻¹ à 50 µm⁻¹.

Les figures 3 à 14 sont des représentations schématiques des différentes étapes mises en oeuvre dans le cadre d'un premier mode de réalisation de la présente invention. Notamment, la figure 3 représente l'enchainement des étapes mises en oeuvre dans le cadre de ce premier mode de réalisation.

Ce premier mode de réalisation implique une étape a) de fourniture du substrat support 11 pourvu d'îlots 17 comprenant l'empilement 12 et sur lesquels un ou des composants actifs sont destinés à être formés.

Les îlots 17 sont délimités latéralement par des flancs, dits premiers flancs 19B, et sont séparés les uns des autres par des tranchées d'isolation 19 qui s'étendent sur au moins toute l'épaisseur de l'empilement 12 jusqu'à un premier fond 19A formé sur ou dans le substrat support 11.

Notamment, le substrat support 11 pourvu des îlots peut notamment être obtenu à partir d'un substrat de semi-conducteur sur isolant 10, qui comprend le substrat support 11 et sur une face duquel, dite face principale 11a, repose l'empilement 12. L'empilement est notamment pourvu, dans l'ordre et à partir de la face principale 11a, d'une couche diélectrique 13 et d'une couche de semi-conducteur 14 (figure 4).

Le substrat support 11 peut comprendre du silicium.

La couche diélectrique 13 peut comprendre du dioxyde de silicium, et présenter une épaisseur comprise entre 15nm et 150nm, plus particulièrement entre 5nm et 50 nm.

La couche de semi-conducteur 14 peut comprendre du silicium, et présenter une épaisseur comprise entre 3nm et 30nm.

L'étape a) peut comprendre les étapes a1), a2), et a3) (figure 3 et figures 4 à 7).

En particulier, l'étape a1) comprend la formation d'une couche de matériau diélectrique 15 (figure 5), formée avantageusement d'une couche d'oxyde de silicium, et en recouvrement de la couche de semi-conducteur 14. La couche de matériau diélectrique 15 peut en particulier comprendre du dioxyde de silicium et présenter une épaisseur comprise entre 5nm et 30nm.

L'étape a2) comprend la formation d'un masque dur 16 (« hard mask » selon la terminologie Anglo-Saxonne), par exemple en nitrure de silicium, sur la couche de matériau diélectrique 15 (figure 6).

La formation du masque dur 16 peut notamment impliquer les étapes suivantes :
- la formation d'une couche de nitrure de silicium, d'une épaisseur comprise entre 5nm et 50nm,
- la définition de zones de masquage 16A au niveau de la couche de nitrure de silicium.

Les zones de masquage 16A délimitent notamment des zones actives 17A (figure 6) qui sont séparées par des espaces, dits espaces vacants 18A. La séparation entre zones actives 17A adjacentes peut présenter une largeur L supérieure à 50 nm, voire supérieure à 500 nm. La définition des zones de masquage 16A peut impliquer dans l'ordre une étape de photolithographie et une étape de gravure.

La formation du masque dur 16 est alors suivie de l'étape a3) qui comprend la formation de tranchées d'isolation 19 (figure 7). Cette étape a3) comprend une étape de gravure, au niveau des espaces vacants 18A, de la couche de matériau diélectrique 15 et de l'empilement 12 de manière à former lesdites tranchées d'isolation 19. Tel qu'illustré à la figure 7, cette étape de gravure permet également de définir plusieurs îlots 17, formant les zones actives 17A. Les îlots 17 sont à cet égard composés de la couche de matériau diélectrique 15 et de l'empilement 12 non gravés, et sont séparés les uns des autres par les tranchées d'isolation 19. Chaque îlot 17 présente également des premiers flancs 19B délimitant latéralement les tranchées d'isolation 19. Chaque tranchée d'isolation 19 s'étend, selon une profondeur Z comprise entre 30nm et 300nm, jusqu'à un premier fond 19A formé sur la face principale 11a du substrat support 11 ou dans le substrat support 11.

Le procédé selon la présente invention peut, ensuite, comprendre une étape e1) de formation d'une couche de protection 20 recouvrant les îlots 17, c'est-à-dire les zones actives 17A et les premiers flancs 19B (figure 8). La formation de la couche de protection 20 peut comprendre, à cet égard, le dépôt d'une couche de nitrure de silicium en recouvrement des zones actives 17A, des premiers flancs 19B et des premier fonds 19A, puis un retrait de ladite couche de nitrure de silicium au niveau uniquement des premiers fonds 19A.

Le procédé selon la présente invention comprend une étape b) de rugosification d'au moins une partie du premier fond 19A des tranchées d'isolation destinée à générer une section passive 21 sur laquelle une moyenne quadratique de rugosité est comprise entre 2 nm et 6 nm (figures 3 et 9).

Selon le premier mode de réalisation, la section passive 21 est directement réalisée sur le premier fond 19A (figure 9). Selon une variante de réalisation, la section passive 21 pourrait être réalisée sur une couche préalablement déposée sur le premier fond 19A.

L'étape b) de rugosification peut comprendre une attaque chimique et plus particulièrement une gravure exécutée au moyen d'une solution de gravure liquide.

La solution de gravure liquide peut avantageusement comprendre au moins une des solutions choisies parmi : solution SC1, solution d'ammoniaque pur, solution TMAH ou KOH. Les concentrations et autres paramètres opératoires (tels que la température, la durée) sont ajustés par l'Homme du métier, afin de générer une moyenne quadratique de rugosité comprise entre 2 nm et 6 nm.

La couche de protection 20 permet de préserver l'intégrité des zones actives 17A et des premiers flancs 19B, c'est-à-dire des îlots 17, lors de l'exécution de l'étape b).

Les tranchées d'isolation 19 sont ensuite remplies d'un premier matériau diélectrique 22 (figure 10) au cours de l'exécution d'une étape e2).

L'étape e2) peut par exemple comprendre les sous-étapes suivantes :
- une sous-étape e2a) de formation d'une couche de matériau diélectrique en recouvrement des tranchées d'isolation 19 et des zones actives 17A.
- une étape e2b) d'aplanissement de la couche de matériau diélectrique conduisant à l'exposition à environnement extérieur de la couche de protection 20 au niveau des zones actives. Cette étape e2b) d'aplanissement est, par exemple, réalisée par un arrêt de gravure sur la couche de protection 20 au niveau des zones actives.

En d'autres termes, à l'issue de l'e2b), les surfaces exposées à l'environnement extérieur du premier matériau diélectrique 22 et de la couche de protection 20 au niveau des zones actives sont en affleurement les unes des autres.

L'étape e2b) peut avantageusement être exécutée par polissage mécano chimique (« CMP » ou « Chemical Mechanical Polishing » selon la terminologie Anglo-Saxonne).

Le premier matériau diélectrique 22 peut comprendre du dioxyde de silicium.

La couche de protection 20 ainsi mise en oeuvre est particulièrement avantageuse à deux titres.

En effet, elle permet en premier lieu de protéger les îlots 17, les premiers flancs 19B lors de l'exécution de l'étape b) de rugosification.

En second lieu, la couche de protection 20 constitue une couche d'arrêt lors de l'exécution de l'étape e2b) d'aplanissement.

L'étape e2) de remplissage des tranchées d'isolation 19 peut être suivie d'une séquence e3) conduisant à la formation des composants actifs 23 sur ou dans la couche de semi-conducteur 14 au niveau des zones actives 17A (figure 11). Cette séquence peut notamment comprendre la formation de grilles, d'extension de source et de drain.

Les composants actifs 23 comprennent par exemple au moins un des composants choisis parmi : un transistor CMOS, un transistor bipolaire, une diode.

L'étape de formation des composants actifs 23 est suivie d'une étape e4) de formation d'une couche d'encapsulation 24 en recouvrement des zones actives 17A et du premier matériau diélectrique 22 remplissant les tranchées d'isolation 19 (figure 12).

La couche d'encapsulation 24 peut comprendre du dioxyde de silicium.

Une couche intermédiaire 25 peut être formée, lors de l'étape e4), entre la couche d'encapsulation 24 et le premier matériau diélectrique 22 remplissant les tranchées d'isolation 19.

La couche intermédiaire 25 est avantageusement faite d'un deuxième matériau différent du premier matériau diélectrique 22 et du matériau formant la couche d'encapsulation. Ces différences entre matériaux permettent notamment de considérer la possibilité de graver ces derniers de manière sélective. Par exemple, la couche intermédiaire 25 peut comprendre du nitrure de silicium.

Le procédé peut comprendre une étape e5) (figure 13), exécutée après l'étape e4), de formation de contacts électriques 26 destinés à contacter électriquement les composants actifs 23. Les contacts électriques 26 traversent notamment la couche d'encapsulation 24, ainsi que la couche intermédiaire 25 si cette dernière est considérée.

La formation des contacts électriques 26 fait appel aux connaissances générales de l'homme du métier et n'est donc pas décrite en détails dans la présente invention.

Le procédé selon la présente invention comprend enfin une étape c) de formation d'un composant, dit composant passif 27, en recouvrement du premier matériau diélectrique 22 et, au moins en partie, à l'aplomb de la section passive 21. Les composants passifs 27 peuvent notamment comprendre des inductances et/ou des composants RF (figure 14).

Par « à l'aplomb de la section passive 21 », on entend un composant passif dont la projection sur la section passive est, au moins en partie, circonscrite par ladite section passive. En d'autres termes, la surface occupée par le composant passif est inférieure à celle de la section passive.

La présente invention comprend également un deuxième mode de réalisation illustré aux figures 15 à 23.

Notamment, la figure 15 est une représentation schématique de l'enchainement des étapes mises en oeuvre selon ce deuxième mode de réalisation.

Ce deuxième mode de réalisation diffère essentiellement du premier mode en ce que les étapes e2), e3) et e4) sont exécutée avant l'étape b) de rugosification, et l'étape e1) est omise.

Par ailleurs, ce deuxième mode de réalisation comprend également l'exécution d'étapes additionnelles nommées e6), e7), e8) et e9), et décrites ci-après.

La structure de départ avant l'étape de rugosification peut différer d'un mode de réalisation à l'autre.

Ainsi, ce deuxième mode de réalisation comprend en premier lieu l'exécution de l'étape a). L'étape a), telle que décrite dans le cadre du premier mode de réalisation, peut comprendre les étapes suivantes :
- l'étape a1) de formation de la couche de matériau diélectrique 15 ;
- l'étape a2) de formation du masque dur 16 ;
- l'étape a3) de formation de tranchées d'isolation 19.

Toujours selon ce deuxième mode de réalisation, l'étape a) est suivie de l'étape e2) de remplissage des tranchées d'isolation 19. L'étape e3) de formation des composants actifs 23 est ensuite réalisée.

Les composants actifs 23 sont, à cet égard, formés sur ou dans la couche de semi-conducteur 14 au niveau des zones actives 17A. Cette séquence peut notamment comprendre la formation de grilles, d'extension de source et de drain.

Les composants actifs 23 comprennent par exemple au moins un des composants choisis parmi : un transistor CMOS, un transistor bipolaire, une diode.

L'étape de formation des composants actifs 23 est suivie de l'étape e4) de formation, dans l'ordre, de la couche intermédiaire 25 et la couche d'encapsulation 24 en recouvrement des zones actives 17A et du premier matériau diélectrique 22 remplissant les tranchées d'isolation 19.

L'étape e5) est exécutée après l'étape e4), pour former les contacts électriques 26 destinés à contacter électriquement les composants actifs 23.

Ainsi, la figure 16 est une illustration du dispositif micro-électronique obtenu à l'issu de l'étape e5) du procédé de fabrication, selon le deuxième mode de réalisation de la présente invention.

Ce deuxième mode de réalisation comprend une étape e6) de formation d'une ouverture traversante 28 traversant les couches d'encapsulation 24 et intermédiaire 25 (figures 17 et 18).

L'ouverture traversante 28 peut par exemple être formée en deux étapes successives qui comprennent dans l'ordre une gravure au niveau de la couche d'encapsulation 24 (figure 17) et une gravure au niveau de la couche intermédiaire 25 (figure 18).

La formation de l'ouverture traversante 28 peut mettre en oeuvre un masque dur 27 (figures 17 et 18).

Par ailleurs, l'ouverture traversante 28 est formée à l'aplomb du premier fond 19A de la tranchée d'isolation 19. Selon l'exemple illustré, l'ouverture traversante 28 est formée à mi-chemin entre deux îlots 17 adjacents. Selon une variante non illustrée, l'ouverture traversante 28 est formée plus près de l'un des deux îlots.

L'ouverture traversante 28 présente une dimension caractéristique D inférieure à un dixième de la largeur L (figure 18). Par exemple, la dimension caractéristique D peut être comprise entre 20nm et 100nm.

Par « dimension caractéristique », on entend une dimension d'une section selon un plan perpendiculaire à l'extension de ladite ouverture traversante. La section peut prendre la forme d'un cercle, d'un carré ou d'un rectangle. La dimension caractéristique d'un cercle est son diamètre, celle d'un carré ou d'un rectangle correspond à une diagonale.

L'ouverture traversante 28 est par ailleurs délimitée par des deuxièmes flancs 28A et par un deuxième fond 28B au niveau duquel le premier matériau diélectrique 22 est exposé à l'environnement extérieur.

Une couche de protection 29 en recouvrement des deuxièmes flancs 28A, et laissant exposé à l'environnement extérieur le deuxième fond 28B peut être formée lors d'une étape e7) (figure 19). La couche de protection 29 peut être de même nature chimique que la couche intermédiaire 25, et par exemple comprendre du nitrure de silicium.

La formation de la couche de protection 29 est suivie d'une étape e8) de gravure sélective du premier matériau diélectrique 22 au regard de la couche de protection 29 et de la couche intermédiaire 25 (figure 20).

En particulier, la gravure est exécutée de manière à former une cavité 31 dans le premier matériau diélectrique 22. La gravure du premier matériau diélectrique 22 est partielle latéralement, et complète sur toute l'épaisseur dudit premier matériau diélectrique. En d'autres termes, cette étape de gravure permet de conserver des blocs 30 du premier matériau diélectrique 22 et de découvrir une section passive 21 au niveau du premier fond 19A. Les blocs 30 portent, par ailleurs, des troisièmes flancs 31A et délimitent ainsi latéralement la cavité 31. En d'autres termes, les blocs 30 isolent ladite cavité 31 des premiers flancs 19B.

La formation de la cavité 31 est alors suivie de l'étape b) de rugosification de la section passive 21 afin de générer, au niveau de ladite section, une moyenne quadratique de rugosité comprise entre 2 nm et 6 nm (figure 21).

La cavité ainsi formée est également délimitée par la section passive 21 au niveau du premier fond 19A et par un plafond 31B au niveau de la couche intermédiaire 25, toutes deux reliées par les troisièmes flancs 31A. Il est entendu, sans qu'il soit nécessaire de le préciser que compte tenu de la présence des blocs 30, la surface de la section passive 21 est inférieure à celle du premier fond 19A.

L'étape b) est alors suivie d'une étape e9) destinée à combler l'ouverture traversante avec un troisième matériau diélectrique 33, par exemple du nitrure de silicium.

Cette étape peut se limiter à combler l'ouverture traversante. Toutefois, le troisième matériau diélectrique peut également tapisser la section passive 21, les troisièmes flancs 31A et le plafond 31B de la cavité 31 (figure 22).

A cet égard, l'étape e9) peut être exécutée au moyen d'un dépôt en couches atomiques (« ALD » ou « Atomic Layer Déposition » selon la terminologie Anglo-Saxonne) du troisième matériau diélectrique.

Cette technique de dépôt connue pour sa conformité permet de déposer sur les deuxièmes parois, les troisièmes parois, la section passive et le plafond une couche comprenant le troisième matériau diélectrique. En particulier, au fur et à mesure de l'avancement de l'étape e9), l'ouverture traversante se remplit du troisième matériau diélectrique jusqu'au moment où cette dernière est complètement obstruée. A cet instant, la formation de la couche de matériau diélectrique dans la cavité 31 cesse, et laisse ainsi une section de volume vide dans ladite cavité.

De manière alternative, l'étape e7) peut comprendre un dépôt chimique en phase vapeur assisté par plasma (« PECVD » ou « Plasma Enhanced Chemical Vapor Déposition » selon la terminologie Anglo-Saxonne).

Le procédé selon la présente invention comprend enfin l'étape c) de formation du composant passif 27, en recouvrement du premier matériau diélectrique 22 et à l'aplomb de la section passive 21 (figure 23). Le composant passif 27 peut notamment comprendre des inductances et/ou des composants RF.

La mise en oeuvre d'une section passive 21 qui présente une rugosité comprise entre 2 nm et 6 nm, et à l'aplomb de laquelle est formée, au moins en partie, le composant passif permet de limiter les diaphonies entre composants passifs, mais également entre les composants actifs 23.

Par ailleurs, la mise en oeuvre de cette section passive permet de s'affranchir de la présence d'une couche de piégeage tel que proposé dans l'état de la technique.

Enfin, la formation des composants passifs, au moins en partie, à l'aplomb des sections passives 21, et par voie de conséquence des tranchées d'isolation 19 permet de répondre favorablement aux problématiques de miniaturisation des composants micro-électroniques.

On notera que dans le cadre de l'invention et comme montré sur la figure 24, lors de l'étape de rugosification de la section passive 21, qu'elle soit selon le premier ou le deuxième mode réalisation, il est possible d'observer c la rugosité de la section passive 21 en réalisant une mesure de microscopie à force atomique en cours de fabrication. Selon cette possibilité, la moyenne de rugosité quadratique et la rugosité peut être calculée au moyen d'images de microscopie à force atomique de 1 µm par 1 µm selon la norme ISO4287. La figure 24 illustre ainsi une image de microscopie à force atomique réalisée sur le premier fond 19A au niveau de la section passive 21 juste après l'étape de rugosification.

Il est à noter que, dans le cadre de l'invention, la caractéristique selon laquelle le dispositif comprend une section passive 21 sur le premier fond 19A des tranchées d'isolation 19 qui présente une moyenne quadratique de rugosité comprise entre 2 nm et 6 nm, alors que la tranchée est remplie par un matériau diélectrique peut être vérifiée de différente façon sur un dispositif micro-électronique fonctionnel :
- soit en effectuant une attaque physico-chimique sélective de manière à supprimer sélectivement le matériau diélectrique et à donner accès à la section passive,
- soit au moyen d'une imagerie électronique en transmission, le dispositif ayant été préalablement aminci pour permettre une telle imagerie.

Ces deux possibilités de mesure, bien que destructives permettent d'apprécier la bonne reproduction de la caractéristique concernant la rugosité des sections passives 21.

## Revendications

1. Procédé de fabrication d'un dispositif microélectronique comprenant :
a) une étape de fourniture d'un substrat de semi-conducteur sur isolant (10) comprenant un substrat support (11) sur une face duquel, dite face principale (11a), repose au moins deux empilements (12) pourvus chacun, dans l'ordre et à partir de la face principale (11a), d'une couche de diélectrique (13) et d'une couche de semi-conducteur (14), chaque empilement (12) formant un îlot (17) sur lesquels un ou des composants actifs sont destinés à être formés, chaque îlot (17) est délimité latéralement par des flancs, dits premiers flancs (19B), et les îlots (17) sont séparés les uns des autres par au moins une tranchée d'isolation (19) qui s'étend sur au moins toute l'épaisseur de l'empilement (12) jusqu'à un premier fond (19A) formé sur ou dans le substrat support (11), chaque tranchée d'isolation étant destinée à être remplie d'un premier matériau diélectrique (22),
b) une étape de rugosification d'une section passive (21) du premier fond (19A) de la tranchée d'isolation (19) destinée à générer, au niveau de ladite section (21), une moyenne quadratique de rugosité comprise entre 2 nm et 6 nm,
c) une étape de formation d'un composant, dit composant passif (27), en recouvrement du premier matériau diélectrique (22) et à l'aplomb de la section passive (21).

2. Procédé selon la revendication 1, dans lequel l'étape b) de rugosification comprend une gravure exécutée au moyen d'une solution de gravure liquide, la solution de gravure liquide comprenant avantageusement au moins une des solutions choisies parmi : solution SC1, solution d'ammoniaque pur, solution TMAH ou KOH.

3. Procédé selon la revendication 1 ou 2, dans lequel l'étape a) comprend l'enchainement des étapes suivantes :
- une étape a1) de formation d'une couche de matériau diélectrique de (15), formé avantageusement d'une couche d'oxyde de silicium, et en recouvrement de la couche de semi-conducteur (14) du substrat de semi-conducteur sur isolant (10) ;
- une étape a2) de formation d'un masque dur 16 destiné à délimiter les tranchées d'isolation (19) ;
- une étape a3) de formation des tranchées d'isolation (19).

4. Procédé selon la revendication 3, dans lequel le procédé comprend une étape e2) de remplissage des tranchées d'isolation (19) par le premier matériau diélectrique (22).

5. Procédé selon la revendication 4, dans lequel le procédé comprend, après exécution de l'étape e2), une séquence e3) conduisant à la formation des composants actifs (23) sur ou dans la couche de semi-conducteur (14) au niveau des îlots (17).

6. Procédé selon la revendication 5, dans lequel le procédé comprend une étape e4), exécutée après la séquence e3), de formation d'une couche d'encapsulation (24) en recouvrement des îlots (17) et du premier matériau remplissant les tranchées d'isolation (19).

7. Procédé selon la revendication 6, dans lequel le procédé comprend une étape e5), exécutée après l'étape e4), de formation de contacts électriques (26) traversant la couche d'encapsulation (24) et destinés à contacter électriquement les composants actifs (23).

8. Procédé selon la revendication 7, dans lequel, lors de l'étape e4), une couche intermédiaire (25) est également formée entre la couche d'encapsulation (24) et le premier matériau remplissant les tranchées d'isolation (19), la couche intermédiaire (25) étant faite d'un deuxième matériau différent du premier matériau et du matériau formant la couche d'encapsulation (24).

9. Procédé selon l'une des revendications 4 à 8, dans lequel l'étape b) est exécutée avant l'étape e2).

10. Procédé selon la revendication 9, dans lequel l'étape b) est précédée d'une étape e1) de formation d'une couche de protection (20) en recouvrement des îlots (17) et des premiers flancs (19B), ladite couche de protection (20) étant destinée à protéger les premiers flancs (19B) de lors de l'exécution de l'étape b).

11. Procédé selon la revendication 8, dans lequel l'étape b) est exécutée après l'étape e4).

12. Procédé selon la revendication 11, dans lequel l'étape b) est précédée d'une séquence qui comprend les étapes suivantes :
- une étape e6) de formation d'une ouverture traversante (28) traversant la couche d'encapsulation (24) et la couche intermédiaire (25), à l'aplomb de la section passive (21), ladite ouverture traversante (28) présentant une dimension caractéristique inférieure à un dixième de la distance entre les premiers flancs (19B) de la tranchée, l'ouverture traversante (28) étant délimitée par des deuxièmes flancs (28A) et un deuxième fond (28B) au niveau duquel le premier matériau diélectrique (22) est exposé à l'environnement extérieur,
- une étape e7) de formation d'une couche de protection (29) en recouvrement des deuxièmes flancs (28A), et laissant exposé à l'environnement extérieur le deuxième fond (28B),
- une étape e8) de gravure sélective et partielle du premier matériau diélectrique (22) au regard de la couche de protection (29) et de la couche intermédiaire (25) de manière à former une cavité (31) dans le premier matériau diélectrique (22) et délimitée par un fond formant la section passive (21), par des troisièmes flancs (31A) formés par le premier matériau diélectrique (22) non gravé au cours de ladite étape de gravure, et par un plafond (31B) au niveau de la couche intermédiaire (25).

13. Procédé selon la revendication 12, dans lequel l'étape b) est suivie d'une étape e9) destinée à combler l'ouverture traversante (28) avec un troisième matériau diélectrique.

14. Procédé selon la revendication 13, dans lequel le troisième matériau diélectrique vient également tapisser la section passive (21), les troisièmes flancs (31A) et le plafond (31B) de la cavité (31).

15. Dispositif micro-électronique comprenant un substrat support (11) présentant une face principale (11a), et des îlots reposant sur la face principale, les îlots comprenant chacun un empilement (12), l'empilement (12) étant pourvu, dans l'ordre et à partir de la face principale (11a), d'une couche diélectrique (13) et d'une couche de semi-conducteur (14), les îlots (17) étant délimités latéralement par des flancs, dits premiers flancs (19B), et étant séparés les uns des autres par des tranchées d'isolation (19) qui s'étendent sur au moins toute l'épaisseur de l'empilement (12) jusqu'à un premier fond (19A) formé sur ou dans le substrat support (11),
le dispositif comprenant une section passive (21) sur le premier fond (19A) des tranchées d'isolation (19) qui présente une moyenne quadratique de rugosité comprise entre 2 nm et 6 nm, et le dispositif comprenant en outre un composant, dit composant passif (27), en recouvrement d'un premier matériau diélectrique (22) remplissant les tranchées d'isolation (19) et à l'aplomb de la section passive (21).

## Patentansprüche

1. Verfahren zum Herstellen einer mikroelektronischen Vorrichtung, das Folgendes umfasst:
a) einen Schritt des Bereitstellens eines Halbleiter-auf-Isolator-Substrats (10), das ein Trägersubstrat (11) umfasst, auf dessen einer Fläche, der sogenannten Hauptfläche (11a), mindestens zwei Stapel (12) liegen, die jeweils in dieser Reihenfolge und beginnend von der Hauptfläche (11a) mit einer dielektrischen Schicht (13) und mit einer Halbleiterschicht (14) versehen sind, wobei jeder Stapel (12) eine Insel (17) bildet, auf der eine oder mehrere aktive Komponenten ausgebildet werden sollen, wobei jede Insel (17) seitlich durch Seitenwände, die sogenannten ersten Seitenwände (19B), begrenzt ist und die Inseln (17) durch mindestens einen Isolationsgraben (19) voneinander getrennt sind, der sich über mindestens die gesamte Dicke des Stapels (12) bis zu einem ersten Boden (19A) erstreckt, der auf oder im Trägersubstrat (11) ausgebildet ist, wobei jeder Isolationsgraben mit einem ersten dielektrischen Material (22) gefüllt werden soll,
b) einen Schritt des Aufrauens eines passiven Abschnitts (21) des ersten Bodens (19A) des Isolationsgrabens (19), der an dem Abschnitt (21) einen quadratischen Mittelwert der Rauheit erzeugen soll, der zwischen 2 nm und 6 nm beträgt,
c) einen Schritt des Bildens einer Komponente, die sogenannte passive Komponente (27), die das erste dielektrische Material (22) bedeckt und senkrecht zum passiven Abschnitt (21) liegt.

2. Verfahren nach Anspruch 1, wobei der Schritt b) des Aufrauens ein Ätzen umfasst, das mittels einer flüssigen Ätzlösung durchgeführt wird, wobei die flüssige Ätzlösung vorteilhafterweise mindestens eine der Lösungen umfasst, ausgewählt aus: einer SC1-Lösung, einer reinen Ammoniaklösung, einer TMAH- oder KOH-Lösung.

3. Verfahren nach Anspruch 1 oder 2, wobei der Schritt a) die Abfolge der folgenden Schritte umfasst:
- einen Schritt a1) des Bildens einer dielektrischen Materialschicht (15), die vorteilhafterweise aus einer Siliziumoxidschicht gebildet ist und die Halbleiterschicht (14) des Halbleiter-auf-Isolator-Substrats (10) bedeckt;
- einen Schritt a2) des Bildens einer Hartmaske (16), die die Isolationsgräben (19) begrenzen soll;
- einen Schritt a3) des Bildens der Isolationsgräben (19).

4. Verfahren nach Anspruch 3, wobei das Verfahren einen Schritt e2) des Füllens der Isolationsgräben (19) mit dem ersten dielektrischen Material (22) umfasst.

5. Verfahren nach Anspruch 4, wobei das Verfahren nach dem Durchführen von Schritt e2) einen Ablauf e3) umfasst, der zum Bilden der aktiven Komponenten (23) auf oder in der Halbleiterschicht (14) auf den Inseln (17) führt.

6. Verfahren nach Anspruch 5, wobei das Verfahren einen nach dem Ablauf e3) durchgeführten Schritt e4) des Bildens einer Kapselungsschicht (24), die die Inseln (17) bedeckt, und des ersten Materials, das die Isolationsgräben (19) füllt, umfasst.

7. Verfahren nach Anspruch 6, wobei das Verfahren einen nach dem Schritt e4) durchgeführten Schritt e5) des Bildens elektrischer Kontakte (26) umfasst, die durch die Kapselungsschicht (24) verlaufen und die aktiven Komponenten (23) elektrisch kontaktieren sollen.

8. Verfahren nach Anspruch 7, wobei in Schritt e4) ebenfalls eine Zwischenschicht (25) zwischen der Kapselungsschicht (24) und dem ersten Material, das die Isolationsgräben (19) füllt, gebildet wird, wobei die Zwischenschicht (25) aus einem zweiten Material hergestellt ist, das sich vom ersten Material und dem Material, das die Einkapselungsschicht (24) bildet, unterscheidet.

9. Verfahren nach einem der Ansprüche 4 bis 8, wobei der Schritt b) vor dem Schritt e2) durchgeführt wird.

10. Verfahren nach Anspruch 9, wobei dem Schritt b) ein Schritt e1) des Bildens einer Schutzschicht (20) vorausgeht, die die Inseln (17) und die ersten Seitenwände (19B) bedeckt, wobei die Schutzschicht (20) die ersten Seitenwände (19B) während des Durchführens von Schritt b) schützen soll.

11. Verfahren nach Anspruch 8, wobei der Schritt b) nach dem Schritt e4) durchgeführt wird.

12. Verfahren nach Anspruch 11, wobei dem Schritt b) ein Ablauf vorausgeht, der die folgenden Schritte umfasst:
- einen Schritt e6) des Bildens einer Durchgangsöffnung (28), die durch die Einkapselungsschicht (24) und die Zwischenschicht (25) senkrecht zum passiven Abschnitt (21) verläuft, wobei die Durchgangsöffnung (28) eine charakteristische Abmessung aufweist, die kleiner als ein Zehntel des Abstands zwischen den ersten Seitenwänden (19B) des Grabens ist, wobei die Durchgangsöffnung (28) durch zweite Seitenwände (28A) und einen zweiten Boden (28B) begrenzt ist, an dem das erste dielektrische Material (22) der äußeren Umgebung ausgesetzt ist,
- einen Schritt e7) des Bildens einer Schutzschicht (29), die die zweiten Seitenwände (28A) bedeckt und dafür sorgt, dass der zweite Boden (28B) der äußeren Umgebung ausgesetzt ist,
- einen Schritt e8) des selektiven und teilweisen Ätzens des ersten dielektrischen Materials (22) gegenüber der Schutzschicht (29) und der Zwischenschicht (25), um einen Hohlraum (31) im ersten dielektrischen Material (22) zu bilden, der durch einen Boden, der den passiven Abschnitt (21) bildet, durch dritte Seitenwände (31A), die durch das erste dielektrische Material (22), das während des Ätzschritts nicht geätzt wurde, gebildet werden, und durch eine Decke (31B) auf der Zwischenschicht (25) begrenzt ist.

13. Verfahren nach Anspruch 12, wobei auf den Schritt b) ein Schritt e9) folgt, der die Durchgangsöffnung (28) mit einem dritten dielektrischen Material ausfüllen soll.

14. Verfahren nach Anspruch 13, wobei das dritte dielektrische Material ebenfalls den passiven Abschnitt (21), die dritten Seitenwände (31A) und die Decke (31B) des Hohlraums (31) auskleidet.

15. Mikroelektronische Vorrichtung, die ein Trägersubstrat (11) umfasst, das eine Hauptfläche (11a) und Inseln aufweist, die auf der Hauptfläche liegen, wobei die Inseln jeweils einen Stapel (12) umfassen, wobei der Stapel (12) in dieser Reihenfolge und beginnend von der Hauptfläche (11a) mit einer dielektrischen Schicht (13) und mit einer Halbleiterschicht (14) versehen sind, wobei die Inseln (17) seitlich durch Seitenwände, die sogenannten ersten Seitenwände (19B), begrenzt sind und durch die Isolationsgräben (19) voneinander getrennt sind, die sich über mindestens die gesamte Dicke des Stapels (12) bis zu einem ersten Boden (19A) erstrecken, der auf oder im Trägersubstrat (11) ausgebildet ist,
wobei die Vorrichtung einen passiven Abschnitt (21) auf dem ersten Boden (19A) der Isolationsgräben (19) umfasst, der einen quadratischen Mittelwert der Rauheit aufweist, der zwischen 2 nm und 6 nm beträgt, und die Vorrichtung ferner eine Komponente, die sogenannte passive Komponente (27), umfasst, die ein erstes dielektrisches Material (22) bedeckt, das die Isolationsgräben (19) füllt und senkrecht zum passiven Abschnitt (21) liegt.

## Claims

1. Method for manufacturing a microelectronic device comprising:
a) a step of providing a semiconductor-on-insulator substrate (10) comprising a support substrate (11) over one face of which, called main face (11a), rests at least two stacks (12) each provided, in this order and starting from the main face (11a), with a dielectric layer (13) and with a semiconductor layer (14), each stack (12) forming an island (17) over which one or several active component(s) are intended to be formed, each island (17) being laterally delimited by sidewalls, called first sidewalls (19B), and the islands (17) being separated from one another by at least one isolation trench (19) which extends over at least the entirety of a thickness of the stack (12) up to a first bottom (19A) formed on or in the support substrate (11), each isolation trench being configured to be filled with a first dielectric material (22),
b) a step of roughening a passive section (21) of the first bottom (19A) of the isolation trench (19) configured to generate, at said section (21), a roughness quadratic mean comprised between 2 nm and 6 nm, and
c) a step of forming a component, called passive component (27), covering the first dielectric material (22) and directly above the passive section (21).

2. Method according to claim 1, wherein the roughening step b) comprises an etching executed by means of a liquid etching solution, the liquid etching solution comprising at least one of the solutions selected amongst: a SC1 solution, a pure ammonia solution, a TMAH or KOH solution.

3. Method according to claim 1 or 2, wherein step a) comprises the sequence of the following steps:
- a step a1) of forming a dielectric material layer (15), formed advantageously by a silicon oxide layer, covering the semiconductor layer (14) of the semiconductor-on-insulator substrate (10);
- a step a2) of forming a hard mask (16) intended to delimit the isolation trenches; and
- a step a3) of forming the isolation trenches (19).

4. Method according to claim 3, wherein the method comprises a step e2) of filling the isolation trenches (19) with the first dielectric material (22).

5. Method according to claim 4, wherein the method comprises, after execution of step e2), a sequence e3) leading to the formation of the active components (23) on or in the semiconductor layer (14) at the islands (17).

6. Method according to claim 5, wherein the method comprises a step e4), executed after the sequence e3), of forming an encapsulation layer (24) covering the islands (17) and the first material filling the isolation trenches (19).

7. Method according to claim 6, wherein the method comprises a step e5), executed after step e4), of forming electrical contacts (26) passing through the encapsulation layer and configured to electrically contact the active components (23).

8. Method according to claim 7, wherein, at step e4), an intermediate layer (25) is also formed between the encapsulation layer and the first material filling the isolation trenches (19), the intermediate layer (25) being made of a second material different from the first material and from the material forming the encapsulation layer (24).

9. Method according to any of the claims 4 to 8, wherein step b) is executed before step e2).

10. Method according to claim 9, wherein step b) is preceded by step e1) of forming a protective layer (20) covering the islands (17) and the first sidewalls (19B), said protective layer (20) being configured to protect the first sidewalls during the execution of step b).

11. Method according to claim 8, wherein step b) is executed after step e4).

12. Method according to claim 11, wherein step b) is preceded by a sequence which comprises the following steps:
- a step e6) of forming a through opening (28) passing through the encapsulation layer (24) and the intermediate layer (25), directly above the passive section (21), said through opening (28) having a characteristic dimension smaller than one-tenth a distance between the first sidewalls (19B) of the trench, the through opening (28) being delimited by second sidewalls (28A) and a second bottom (28B) at which the first dielectric material (22) is exposed to the external environment,
- a step e7) of forming a protective layer (29) covering the second sidewalls (28A), and leaving the second bottom (28B) exposed to the external environment, and
- a step e8) of selective and partial etching the first dielectric material (22) opposite the protective layer (29) and the intermediate layer (25) so as to form a cavity (31) in the first dielectric material (22) and delimited by a bottom forming the passive section (21), by third sidewalls (31A) formed by the first dielectric material that has not been etched during said etching step, and by a ceiling (31B) at the intermediate layer (25).

13. Method according to claim 12, wherein step b) is followed by a step e9) configured to fill in the through opening (28) with a third dielectric material.

14. Method according to claim 13, wherein the third dielectric material also lines the passive section (21), the third sidewalls (31A) and the ceiling (31B) of the cavity (31).

15. Microelectronic device comprising a support substrate (11) having a main face (11a), and islands resting on the main face, each of the islands comprising a stack (12), the stack (12) being provided, in this order and starting from the main face (11a), with a dielectric layer (13) and with a semiconductor layer (12), the islands (17) being laterally delimited by sidewalls, called first sidewalls (19B), and being separated from one another by isolation trenches (19) which extend over at least the entirety of the thickness of the stack (12) up to a first bottom (19A) formed on or in the support substrate (11),
the device comprising a passive section (21) on the first bottom of the isolation trenches (19) which has a roughness quadratic mean comprised between 2 nm and 6 nm, and the device further comprising a component, called passive component (27), covering a first dielectric material (22) filling the isolation trenches (19) and directly above the passive section (21).
